Europäisches Patentamt

European Patent Office

Office européen des brevets

(11) Numéro de publication: **0 295 973 B1**

(19)

## (12) FASCICULE DE BREVET EUROPEEN

(45) Date de publication de fascicule du brevet: **23.12.92**

(51) Int. Cl.⁵: **H04B 1/56,** H03F 3/24, H03F 1/28

(21) Numéro de dépôt: **88401087.7**

(22) Date de dépôt: **04.05.88**

(54) **Montage réducteur de bruit pour amplificateur en hyperfréquences et liaison amplificateur-antenne comportant au moins un tel montage.**

(30) Priorité: **26.05.87 FR 8707417**

(43) Date de publication de la demande: **21.12.88 Bulletin 88/51**

(45) Mention de la délivrance du brevet: **23.12.92 Bulletin 92/52**

(84) Etats contractants désignés: **DE GB IT**

(56) Documents cités: **GB-A- 733 358** **US-A- 2 970 276** **US-A- 4 520 476**

(73) Titulaire: **THOMSON-CSF 51, Esplanade du Général de Gaulle F-92800 Puteaux(FR)**

(72) Inventeur: **Fleury, Georges THOMSON-CSF SCPI 19, avenue de Messine F-75008 Paris(FR)** Inventeur: **Epsztein, Bernard THOMSON-CSF SCPI 19, avenue de Messine F-75008 Paris(FR)**

(74) Mandataire: **Courtellemont, Alain et al THOMSON-CSF SCP B.P. 329 F-92402 COURBEVOIE CEDEX(FR)**

EP 0 295 973 B1

## Description

La présente invention concerne un montage réducteur de bruit pour amplificateur travaillant, par impulsions, en hyperfréquences ; elle concerne également une liaison amplificateur-antenne comportant au moins un tel montage.

A la sortie des amplificateurs, le bruit engendré par ces amplificateurs est supérieur ou égal au produit du bruit thermique à l'entrée de l'amplificateur par le facteur de bruit de l'amplificateur et par le gain de l'amplificateur. Ainsi, par exemple, un tube hyperfréquence amplificateur de puissance ayant un facteur de bruit de 30 à 40 dB et un gain de 50 dB, présente sur sa sortie de puissance un bruit qui est au moins 80 à 90 dB au dessus du bruit thermique ; dans le cas où un élément constituant une source de bruit est placé devant l'amplificateur, la puissance de bruit à la sortie de l'amplificateur est encore supérieure.

Pour éliminer le bruit généré par un amplificateur, il est connu par le brevet US - A - 2 970 276 de disposer respectivement en amont et en aval de l'amplificateur deux interrupteurs commandés simultanément à une fréquence bien supérieure à la fréquence principale du spectre de bruit et d'effectuer une soustraction entre les signaux de sortie de l'amplificateur quand il reçoit un signal d'entrée et quand il n'en reçoit pas. Une telle solution est difficilement applicable en hyperfréquences car la réalisation d'interrupteurs fonctionnant à des fréquences nettement supérieures à celles de l'amplificateur est onéreuse ; la réalisation des deux interrupteurs est même pratiquement impossible dans l'état actuel de la technique si l'amplificateur est un amplificateur de puissance.

Dans certaines applications, lorsque l'amplificateur est couplé à une antenne qui sert à la fois à l'émission et à la réception, le bruit engendré par le tube hyperfréquence peut gêner la réception des signaux reçus à bas niveaux, car il existe un couplage parasite entre l'amplificateur de puissance et le récepteur. Lorsque l'émission et la réception ne se font pas dans la même bande de fréquences, un filtre sélectif peut être utilisé, de préférence dans la voie réception, afin d'éliminer le bruit. Ceci n'est pas possible lorsque l'émission et la réception se font séquentiellement dans le temps, c'est à dire lorsque l'émission s'effectue par impulsions, un signal étant émis durant les impulsions et la réception s'effectuant durant les "silences" d'émission. Il existe alors un moyen connu pour réduire le niveau de bruit durant les "silences" : le faisceau électronique du tube amplificateur est coupé, par exemple en utilisant une grille commandée à faible niveau ; le bruit n'existe alors pratiquement plus à la sortie et par conséquent, il n'y a plus de gêne à la réception.

Cette méthode, très efficace, n'est néanmoins pas sans inconvénient. Elle suppose l'utilisation d'un tube à grille et d'un modulateur de commande de grille ; il en résulte une augmentation du coût et une réduction de la fiabilité et de la durée de vie de l'équipement.

La présente invention a pour but de réduire le bruit durant les "silences" sans avoir recours aux grilles commandées.

Ceci est obtenu en dérivant une faible partie du signal de sortie de l'amplificateur et en le traitant en amplitude et en phase pour pouvoir, en le recombinant ensuite à l'autre partie du signal de sortie de l'amplificateur, éliminer le bruit pendant les "silences".

Selon l'invention un montage réducteur de bruit pour amplificateur en hyperfréquences fonctionnant par impulsions, est caractérisé en ce qu'il comporte : un premier coupleur ayant une entrée couplée à l'amplificateur une sortie principale et une sortie auxiliaire ; un second coupleur ayant une entrée principale couplée à la sortie principale du premier coupleur, une entrée secondaire et une sortie qui constitue la sortie du montage ; et, en série entre la sortie auxiliaire du premier coupleur et l'entrée secondaire du second coupleur, un circuit limiteur de tension, un circuit d'amplification et un circuit déphaseur, en ce que le gain du circuit d'amplification est, au moins sensiblement, égal à la somme des coefficients de couplage des deux coupleurs, et en ce que le circuit déphaseur est réglé pour que, entre les impulsions de fonctionnement de l'amplificateur, les signaux arrivant sur les deux entrées du second coupleur se combinent en opposition de phase dans le second coupleur.

Il est à noter qu'il est connu par le brevet US-A 4 520 476 de réaliser un émetteur-récepteur à antenne unique qui comporte entre l'émetteur et l'antenne deux coupleurs montés, l'un par rapport à l'autre, comme indiqué dans le paragraphe ci-avant ; ces deux coupleurs ne sont pas destinés à réduire le bruit de l'émetteur c'est-à-dire à améliorer le signal fourni à l'antenne, mais à faire qu'au signal fourni au récepteur ne se mêle pas une partie du signal de l'émetteur.

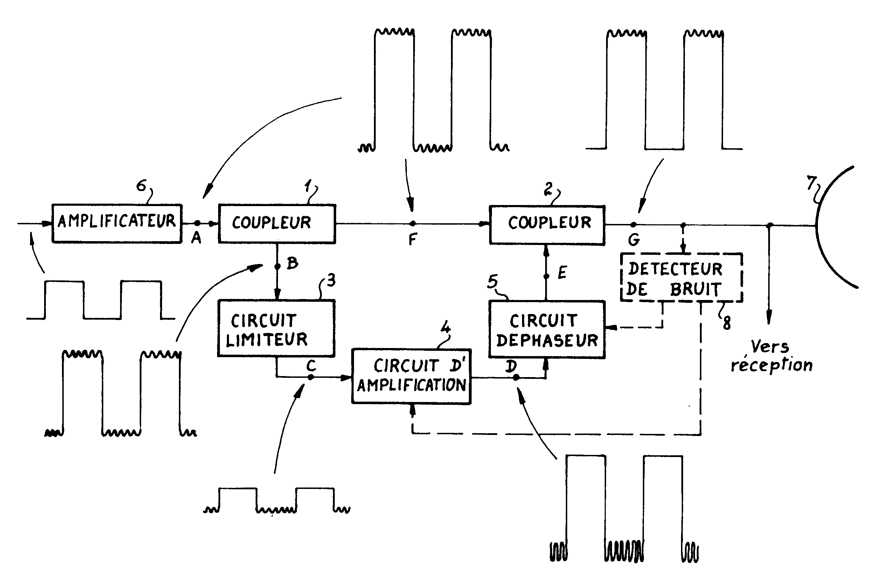

La présente invention sera mieux comprise et d'autres caractéristiques apparaîtront à l'aide de la description ci-après et de la figure s'y rapportant qui représente un amplificateur pour émission en hyperfréquences couplé à une antenne par un montage selon l'invention.

La figure représente un amplificateur, 6, constitué par un tube hyperfréquence. Cet amplificateur est destiné à amplifier un signal hyperfréquence à émettre par une antenne 7. Le signal d'entrée de l'amplificateur ainsi que divers autres signaux du montage ont été représentés sur la figure ; dans les dessins de ces signaux les amplitudes n'ont pu être respectées, certains de ces signaux correspondant à des puissances de 1kW, d'autres à des puissances de quelques dizaines de milliwatts.

Le signal à amplifier est fait d'impulsions et, entre ces impulsions, un circuit de réception branché sur l'antenne 7 doit pouvoir recevoir.

La sortie de l'amplificateur 6 (repère A) est reliée à l'entrée d'un coupleur directif 1 dont la sortie principale ou sortie à fort niveau (repère F) est reliée à l'entrée principale d'un autre coupleur directif, 2, et dont la sortie auxiliaire ou sortie à faible niveau (repère B) est reliée à l'entrée d'un circuit limiteur de tension, 3, dont la sortie (repère C) est reliée à l'entrée d'un circuit d'amplification, 4.

La sortie (repère D) du circuit d'amplification, 4, est reliée à l'entrée d'un circuit déphaseur, 5, dont la sortie (repère E) est reliée à l'entrée auxiliaire du coupleur directif, 2.

La sortie (repère G) du coupleur 2 est reliée à l'accès de l'antenne 7 et, de cet accès, part une liaison vers un récepteur non représenté sur la figure.

Dans la réalisation, qui a servi à la présente description, la puissance de sortie hyperfréquence de l'amplificateur 6 est de 1 kW, soit 60 dBm, la bande à 3 dB de cet amplificateur est d'environ 1000 MHz, son facteur de bruit de l'ordre de 40 dB et son gain voisin de 50 dB. Dans ces conditions le niveau de bruit en A, c'est à dire à la sortie de l'amplificateur, est de l'ordre de + 5 dBm.

Le coupleur 1 ayant un coefficient de couplage (c'est à dire un rapport de puissance dans la transmission entre son entrée et sa sortie auxiliaire) C1 = 30 dB, pratiquement toute la puissance fournie par l'amplificateur 6 est transmise par la sortie principale de ce coupleur sur la voie directe qui, par F, arrive au coupleur 2. Par contre, dans la voie dérivée c'est à dire la voie passant par les circuits 3, 4 et 5, en B le signal utile a un niveau de 60 dBm - C1 = 30 dBm et le bruit un niveau de 5 dBm - C1 = - 25 dBm.

Le seuil du circuit limiteur 3 est réglé, dans l'exemple décrit, à 10 dB au dessus du niveau moyen du bruit ; en C le signal a donc un niveau de 5 dBm - C1 + 10 dB = - 15 dBm tandis que le bruit, qui est inférieur à la limite, garde sa valeur, soit 5 dBm - C1 = - 25 dBm.

Le circuit amplificateur 4 a un gain égal à C1 + C2 où C2 est le coefficient de couplage du coupleur 2 ; dans l'exemple décrit C2 = C1 = 30 dB. En D le signal utile a donc un niveau de 15 dBm + C2 = 45 dBm et le bruit atteint 5dBm + C2 = 35 dBm.

Le circuit déphaseur 5 est réglé pour que, à l'intérieur du coupleur 2, les signaux de bruit provenant de la voie directe et ceux provenant de la voie dérivée se combinent en opposition de phase ; comme ils ont sensiblement une même amplitude de 5 dBm au moment où ils se combinent, ils s'annulent. Ainsi le bruit est éliminé entre les impulsions hyperfréquence, tandis que le signal utile n'est pratiquement pas perturbé étant donné que son niveau en E est très faible relativement au signal utile dans la voie directe.

Il est à noter que la réduction de bruit obtenue, par des montages du type de celui qui vient d'être décrit est de l'ordre de 10 à 20 dB suivant la largeur de bande de fonctionnement en hyperfréquences.

La présente invention n'est pas limitée à l'exemple décrit ; c'est ainsi, en particulier, que le seuil du circuit limiteur 3 peut être réglé différemment suivant la bande hyperfréquence dans laquelle le bruit doit être éliminé. De même la fonction de limitation du circuit 3 peut être associée, dans un même circuit, à la fonction d'amplification du circuit 4, étant entendu que la fonction d'amplification doit toujours être assurée avec un faible facteur de bruit de façon à ne pas engendrer un signal parasite pouvant affecter le signal de bruit provenant de l'amplificateur 6 et transmis par la voie dérivée.

Dans le cas où la réduction de bruit obtenue avec un montage comme celui qui vient d'être décrit n'est pas suffisante plusieurs montages de ce type peuvent être mis en série entre l'amplificateur et l'antenne.

Par ailleurs le montage qui vient d'être décrit peut être complété pour fonctionner en boucle fermé, comme indiqué en traits interrompus sur la figure. Pour cela un détecteur de bruit, 8, mesure, en dehors de la bande de fonctionnement hyperfréquence, l'amplitude et la phase du signal de bruit en G et réagit sur le coefficient d'amplification du circuit 4 et sur la phase du circuit 5 pour tendre à annuler le bruit ainsi mesuré.

## Revendications

1. Montage réducteur de bruit pour amplificateur en hyperfréquences fonctionnant par impulsions, caractérisé en ce qu'il comporte : un premier coupleur (1) ayant une entrée couplée à l'amplificateur une sortie principale et une sortie auxiliaire ; un second coupleur (2) ayant une entrée principale couplée à la sortie principale du premier coupleur, une entrée secondaire et une sortie qui constitue la sortie du montage ; et, en série entre la sortie auxiliaire du premier coupleur (1) et l'entrée secondaire du second coupleur (2), un circuit limiteur de tension (3), un circuit d'amplification (4) et un circuit déphaseur(5), en ce que le gain du circuit d'amplification (4) est, au moins sensiblement, égal à la somme des coefficient de couplage des deux coupleurs, et en ce que le circuit déphaseur (5) est réglé pour que, entre les impulsions de fonctionnement de l'amplificateur, les signaux arrivant sur les deux entrées du second coupleur (2) se combinent en opposition de phase dans le second coupleur.

2. Montage selon la revendication 1, caractérisé en ce qu'il comporte un détecteur de bruit (8) couplé à la sortie du second coupleur (2) pour commander le gain du circuit d'amplification (4) et le déphasage du circuit déphaseur (5).

3. Liaison entre un amplificateur et une antenne, caractérisée en ce qu'elle comporte en série n montages selon l'une au moins des revendications précédentes où n est un nombre entier supérieur à 0.

## Claims

1. A noise-reducing assembly for an amplifier at ultra-high frequencies operating by pulses, characterised in that it comprises : a first coupler (1) having an input coupled to the amplifier, a principal output and an auxiliary output; a second coupler (2) having a principal input coupled to the principal output of the first coupler, a secondary input and an output which constitutes the output of the assembly ; and, in series between the auxiliary output of the first coupler (1) and the secondary input of the second coupler (2), a voltage limiter circuit (3), an amplification circuit (4) and a phase shifter circuit (5),in that the gain of the amplification circuit (4) is, at least substantially, equal to the sum of the coefficients of coupling of the two couplers, and in that the phase shifter circuit (5) is regulated such that, between the operation pulses of the amplifier, the signals arriving at the two inputs of the second coupler (2) are combined in phase opposition in the second coupler.

2. An assembly according to Claim 1, characterised in that it comprises a noise detector (8) coupled to the output of the second coupler (2) to control the gain of the amplification circuit (4) and the phase shifting of the phase shifter circuit (5).

3. A connection between an amplifier and an antenna, characterised in that it comprises in series n assemblies according to at least one of the preceding claims in which n is a whole number greater than 0.

## Patentansprüche

1. Schaltung zur Reduzierung des Rauschens in einem Mikrowellenimpulsverstärker, dadurch gekennzeichnet, daß sie aufweist: einen ersten Koppler (1) mit einem an den Verstärker gekoppelten Eingang, einem Hauptausgang und einem Hilfsausgang, einen zweiten Koppler (2) mit einem an den Hauptausgang des ersten Kopplers gekoppelten Haupteingang, einem Zweiteingang und einem den Ausgang der Schaltung bildenden Ausgang, und einen Spannungsbegrenzerkreis (3), einen Verstärkungskreis (4) und einen Phasenschieberkreis (5) in Reihe zwischen dem Hilfsausgang des ersten Kopplers (1) und dem Zweiteingang des zweiten Kopplers (2), daß der Verstärkungsgrad des Verstärkungskreises (4) zumindest im wesentlichen gleich der Summe der Kopplungskoeffizienten der beiden Koppler ist und daß der Phasenschieberkreis (5) so eingestellt ist, daß zwischen den Impulsperioden des Verstärkers die an den beiden Eingängen des zweiten Kopplers (2) ankommenden Signale sich gegenphasig im zweiten Koppler ergänzen.

2. Schaltung nach Anspruch 1, dadurch gekennzeichnet, daß sie einen an den Ausgang des zweiten Kopplers (2) gekoppelten Rauschdetektor (8) aufweist, um den Verstärkungsgrad des Verstärkungskreises (4) und die Phasenverschiebung des Phasenschieberkreises (5) zu steuern.

3. Verbindung zwischen einem Verstärker und einer Antenne, dadurch gekennzeichnet, daß sie in Reihe n Schaltungen gemäß einem der vorhergehenden Ansprüche enthält, wobei n eine positive ganze Zahl ist.